# EUROPEAN PATENT SPECIFICATION

(11) **EP 0 437 129 B1**
(45) Date of publication and mention of the grant of the patent: **10.04.1996**
(21) Application number: 90403584.7
(22) Date of filing: 13.12.1990
(51) Int. Cl.: G11C 5/14, H02J 9/06

(54) **Card type semiconductor device**
Kartenartige Halbleiteranordnung
Dispositif à semi-conducteurs de type à carte

(30) Priority: 13.12.1989 JP 321535/89
(43) Date of publication of application: 17.07.1991
(73) Proprietor: FUJITSU LIMITED, Kawasaki-shi, Kanagawa 211 (JP); FUJITSU VLSI LIMITED, Kasugai-shi Aichi 487 (JP)
(72) Inventor: Tanaka, Ryuji, Kawasaki-shi, Kanagawa 213 (JP)
(74) Representative: Joly, Jean-Jacques

(56) References cited:
- GB-A- 2 205 697
- JP-A-61 160 185
- US-A- 4 779 037
- PATENT ABSTRACTS OF JAPAN vol. 7, no. 286 (P-244)21 December 1983 & JP-A-58 160 959 ( RICOH ) 24 September 1983
- PATENT ABSTRACTS OF JAPAN vol. 9, no. 101 (P-353)2 May 1985 & JP- A-59 225 417 ( HITACHI ) 18 December 1984
- PATENT ABSTRACTS OF JAPAN vol. 7, no. 172 (P-213)29 July 1983 & JP-A- 58 078 212 ( TOSHIBA ) 11 May 1983

## Description

### BACKGROUND OF THE INVENTION

### 1. Field of the Invention

The present invention relates to a card type semiconductor device, for example, a memory card device or an IC card including a microprocessor, for use in the field of portable personal computers, word processors, and other systems, and more particularly relates to a memory card device having a memory device which requires a constant supply of power for holding data, and a countermeasure means against disconnection of a battery terminal.

### 2. Description of the Related Art

In recent years, there has been an increase in the use of portable personal computers, word processors, and other systems. The systems themselves have mostly become battery driven types in view of the emphasis on mobility. Due to the fact that they are battery driven, it is desirable that the memory cards do not consume much of the system power when mounted in the system, and that the system can be operated without excessive trouble, for example, such as when a malfunction due to disconnection of a battery occurs.

Further, memory cards carrying secondary batteries suffer from a decline in their charging efficiency when the secondary batteries have been over-discharged and require a long time for charging to the voltage required for holding the memory data.

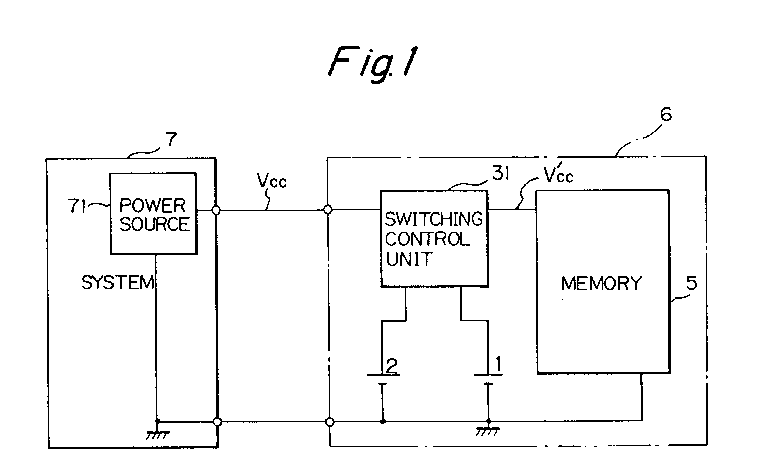

In the past, one of this type of memory cards was that shown in Fig. 1. Figure 1 is a schematic view of a conventional memory card. In the figure, the conventional memory card 6 is comprised of a primary battery 1 which is not rechargeable, for supplying current for holding data to the memory 5 during separation from a system 7, a secondary battery 2 which is rechargeable, for supplying current for holding data to the memory 5 during replacement of the primary battery 1, and a switching control unit 31 for controlling the circuit switching to supply power to the memory 5 and the secondary battery 2 from the system 7 side during mounting in the system 7.

In this case, the primary battery is a battery such as a lithium cell which is used as a back-up cell and which can be exchanged when consumed, the secondary battery is a battery such a cadmium cell which is built into the memory card device, cannot be exchanged, and must be charged as soon as possible when an operator begins to use the system, for example, a personal computer, in which the battery is used.

Next, an explanation will be given of the operation of a conventional memory card based on the above construction. When the memory card is mounted in the system 7, current for holding the memory is supplied from the system 7 side to the memory 5 and charging current is supplied to the secondary battery.

Further, when the memory card is separated from the system 7, current for holding data is constantly supplied from primary battery 1 to the memory 5. In this state, when the potential level of the primary battery 1 falls and the battery is replaced, current for holding data is supplied to the memory 5 from the secondary battery simultaneously with the removal of the primary battery 1.

Due to the conventional memory cards being constructed in the above way, if a memory card were not mounted in the system for a certain period of time, the secondary battery would not be charged to the potential required for holding the data and there was a problem that the primary battery could not be replaced with the memory card separated from the system 7, i.e., before mounting. A memory card that can be carried is a single unit in a portable form. For example, in the above case, if a user accidentally drops tne memory card or removes the primary battery for amusement, the power supply may be cut off instantaneously. For this reason, if a secondary battery is not charged up entirely the stored data may be destroyed.

Further, since the only source of supply of the power for charging the secondary battery was the system 7, there were more frequent cases of the over-discharged state, resulting in the problem of a decline in the charging efficiency and a long time required for charging. Also, since the charging of the secondary battery was performed by charging only from the system 7 side, there was also the problem that the power of the system 7 side was consumed and the lifetime of the power source at the system 7 side was reduced.

For an example of a memory card equipped with a main battery and a back-up battery as per the preamble of claim 1, reference may be made to JP-A-61 116 185.

### SUMMARY OF THE INVENTION

The present invention was made to resolve the above problems and has as its object the provision of a memory card type semiconductor device wherein it is possible to replace a primary battery immediately after a fall in the potential of the primary battery even before mounting in a system and wherein it is possible to charge a secondary battery for backing up the primary battery in an extremely short time.

According to an aspect of the present invention, there is provided a card type semiconductor device including a terminal for receiving an external power source voltage, a semiconductor device operatively connected to the terminal, a primary battery for supplying a first power source voltage, a secondary battery for supplying a second power source voltage, a first switching means for supplying the first power source voltage from the primary battery to the semiconductor device, when the external power source voltage is not supplied, a second switching means for supplying the second power source voltage from the secondary battery to the semiconductor device, when the first power source voltage is not supplied, and means for charging the secondary battery by the first power source voltage supplied from the primary battery. The specific inter-relation of these features is defined in claim 1.

In the present invention, since the secondary power source is charged from the system power source and the primary power source during mounting in the system, the secondary power source is charged from the primary power source during separation from the system, and current for holding the data is supplied from the secondary power source to the memory device during replacement of the primary power source, it is possible to fully charge the secondary power source immediately before mounting in the system or in a short time after mounting and to smoothly replace the first power source. Further, when the system is battery driven, it is possible to prevent reduction of the power source lifetime of the system.

### BRIEF DESCRIPTION OF THE DRAWINGS

Figure 1 is a schematic view of a conventional memory card;
Fig. 2 is a schematic view of a memory card as an embodiment of the present invention;
Figs. 3(A) and 3(B) are views for explaining the operation of the embodiment of Fig. 2;
Figs. 4(A) and 4(B) are views for explaining the charging operation of the embodiment of Fig. 2 in comparison with the prior art;
Fig. 5 is a schematic view of a memory card device according to another embodiment of the present invention;
Fig. 6 is a connection diagram of a 16-pin or 20-pin TSOP (Thin small outline package) IC 11 of a switching control circuit in Fig. 2 and a memory device 5;
Figs. 7(A) and 7(B) are timing charts of an input/output voltage and an alarm operation;
Fig. 8 is a detailed circuit diagram of a switching control unit IC in Fig. 6;
Fig. 9 is a timing chart of a system including a memory card device in accordance with the present invention;
Fig. 10 is a block diagram of a memory card including a memory such as a 256K SRAM;
Fig. 11 is a functional block diagram of the memory card device in Fig. 10; and
Fig. 12 is an oblique projection drawing with a partial cross-sectional view of an IC card in accordance with the present invention.

### DESCRIPTION OF THE PREFERRED EMBODIMENTS

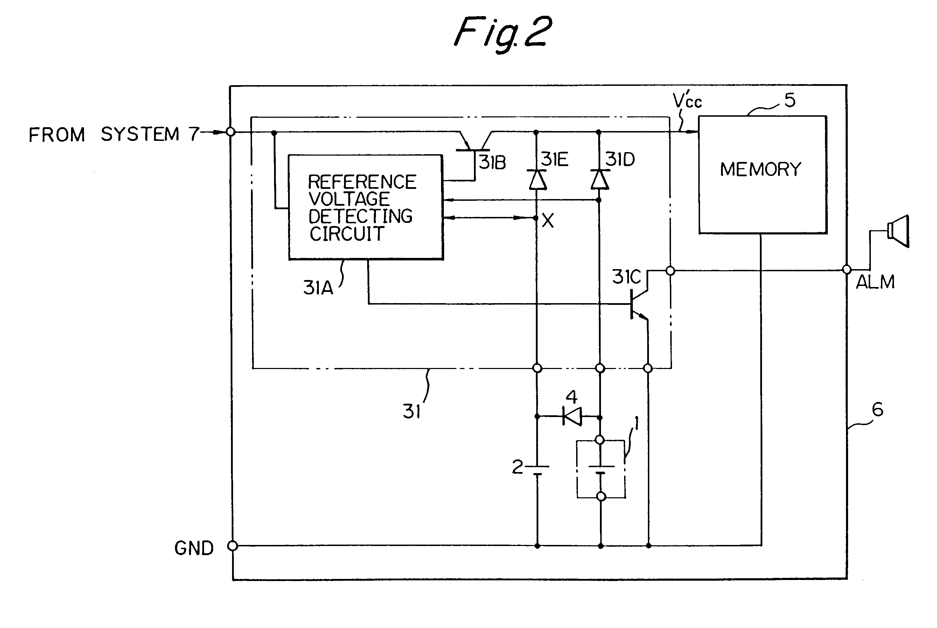

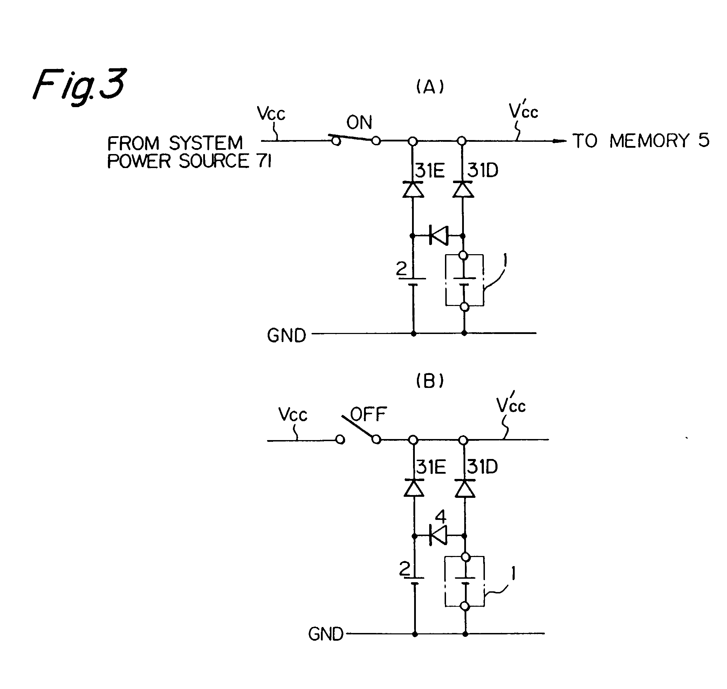

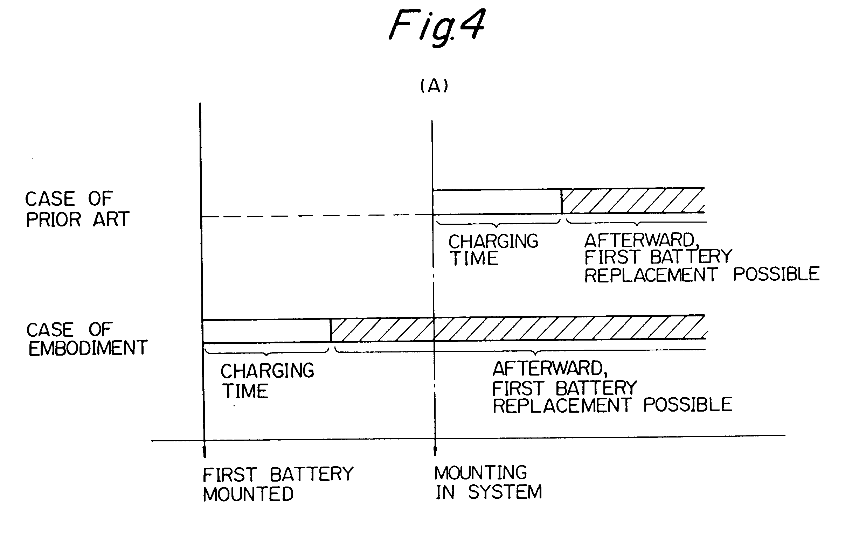

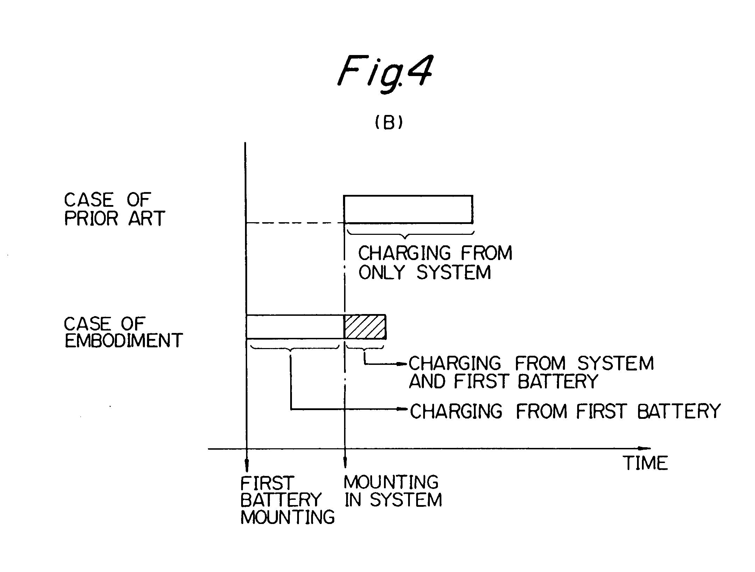

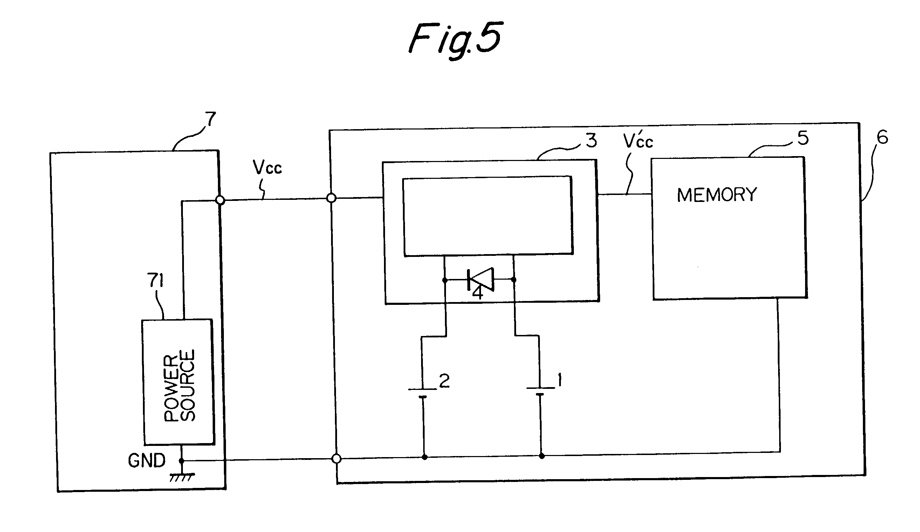

Below, an explanation will be given of an embodiment of the present invention based on Fig. 2 and Fig. 3. Figure 2 is a schematic view of a memory card of the present embodiment, and Figs. 3(A) and (B) are views for explaining the operation of the embodiment.

In the above figures, the memory card of the present embodiment, like the prior art, is comprised of a primary battery 1, secondary battery which is rechargeable 2, and memory 5 housed in a card body 6. The memory 5 is a volatile memory such as a static RAM, a dynamic RAM or the like. When a microprocessor chip or a power source is turned off, the memory contents are not maintained. The present invention also includes a card device which contains ICs, or semiconductor devices. In addition to the above construction, the memory card of the embodiment is provided with a diode 4 connected so that the direction of current from the primary battery 1 to the secondary battery 2 is biased forward between the output sides of the primary battery 1 and the secondary battery 2 and a switching control circuit 31 which detects the potential levels of the primary battery 1 and the secondary battery 2 and controls the connections among the primary battery 1, the secondary battery 2, the memory 5, and the system 7.

The above-mentioned switching control unit 31 is provided with a reference voltage detecting circuit 31A which compares the potential levels of the primary battery 1, secondary battery 2, and the power supply potential V_{CC} of the system 7 side with a predetermined reference potential, a transistor 31B for supplying current for holding data from the power supply of the system 7 to the memory 5, a transistor 31C for issuing a warning, based on the results of the comparison of the above-mentioned voltage detecting circuit 31A, to the effect that the drive state of the transistor 31C has been entered and the primary battery 1 should be exchanged, a diode 31D connected so that the current supply from the primary battery 1 to the memory 5 is biased forward, and a diode 31E connected so that the current supply from the secondary battery 2 to the memory 5 side is biased forward.

The power source voltage of the system 7 is higher than the battery voltage delivered for maintaining data such as the primary battery 1. While the memory card 6 is mounted in the system 7 such as a personal computer, the power source voltage from the system 7 is supplied to the secondary battery through a reference voltage detecting circuit 31A and a connection node X. A voltage higher than the voltage level of the primary battery is produced by a level transformation of a power source voltage V_{CC} from the system 7 side.

In a prior art IC card device, as shown in Fig. 1, since the secondary battery is charged through a switching control unit 3, the power consumption increases while the secondary battery is being charged. Contrary to this, in accordance with the present invention, charging is carried out from the primary battery through a diode 4. Since the secondary battery can be charged without charging current passing through the reference voltage detecting circuit 31A in which power is consumed, wasteful power consumption of the battery at the system side can be reduced.

Further, when the memory card 6 is disconnected from the system 7, the secondary battery supplies a power source voltage to the memory 5 until the voltage of the secondary battery becomes lower than that of the primary battery. Thus, the supply of power from the primary battery to the memory 5 is minimized advantageously.

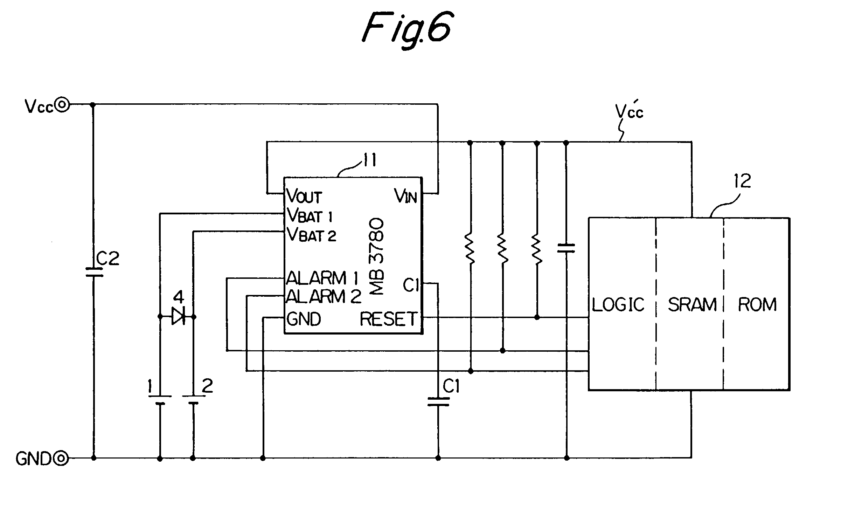

Next, an explanation will be given of the operation of the present embodiment based on the above construction with reference to Fig. 3 and Fig. 4. Figure 4 is a view for explaining the charging operation of the present embodiment in comparison with the prior art.

First, when mounting the memory card in the system 7, whether or not the power supply voltage V_{CC} of the system 7 has reached a predetermined reference potential value or more is determined by the reference voltage detecting circuit 31A. If one is over the reference potential value, the transistor 31B enters a drive state to give the connection configuration shown in Fig. 3(A) and the switch in the reference voltage detecting circuit 31A (illustration omitted in Fig. 2) is turned on. Due to the connection configuration of Fig. 3(A), current for holding the data is supplied from the power supply of the system 7 through the transistor 31B in the drive state to the memory 5. Further, charging current is supplied through the on state switch from the power supply of the system 7 to the secondary battery 2. The supply of charging current to the secondary battery 2 may also be performed by supplying current from the primary battery 1 along with the current of the system 7 side (see hatching portion of Fig. 4(B)) so as to speedily charge the battery and to reduce the power consumption of the system 7 as much as possible.

Next, when the memory card is separated from the system 7, whether or not the potential level of the battery 1 is higher than a predetermined current required for holding the data is determined by the reference voltage detecting circuit 31A. If above the predetermined potential, current for holding the data is supplied from the primary battery 1 to the memory 5. Further, at the above potential level, whether or not the potential of the primary battery 1 is higher than the potential of the secondary battery 2 is determined by the reference voltage detecting circuit 31A. During the time when the potential of the primary battery 1 is higher, the diode 4 is forward biased and charging current is supplied from the primary battery 1 to the secondary battery 2. In this way, even in the state where the memory card is separated from the system 7, there is charging from the primary battery 1, so even before remounting in the system 7, replacement of the primary battery 1 becomes possible (see hatched portion of Fig. 4(A)). It therefore becomes possible to ensure full charging at the system 7 in a short time and to reduce the current consumption at the system 7 as much as possible.

Further, when the above memory card is separated from the system 7 and the reference voltage detecting circuit 31A discriminates that the potential level of the primary battery 1 is below a predetermined value, a signal indicating a drop in the voltage is output to a buzzer 8 and the memory card device produces a warning signal to warn that the primary battery 1 should be replaced.

When the primary battery 1 is removed based on the above battery replacement warning, the connection becomes as shown in Fig. 3(B) and current for holding the memory is supplied for a backup by the secondary battery 2 to the memory 5.

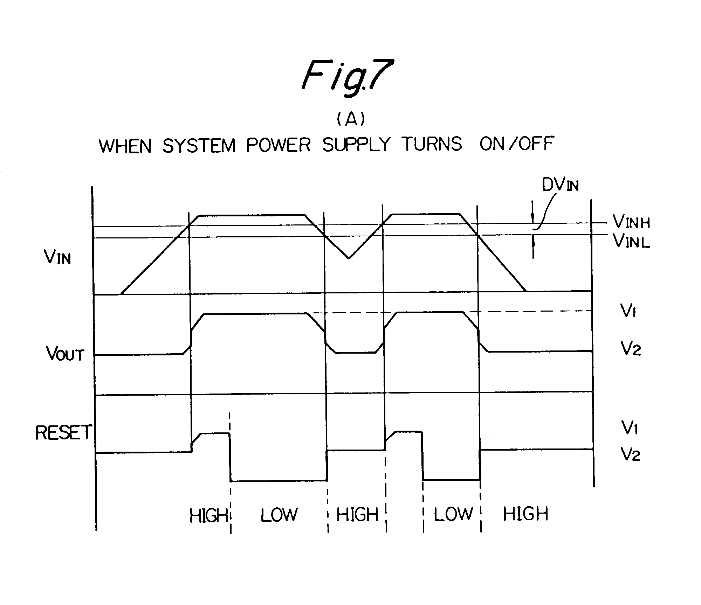

Note that in the above embodiment, a diode 4 was connected to the outside of the power control unit 3, but as shown in Fig. 5, as one of the functions of the power control unit 3, it is possible to make the construction so as to supply power for charging the secondary battery 2 from the battery 1 at all times when the potential of the battery 1 is higher than the potential of the secondary battery 2. Further, it is possible to construct this circuit as an IC (integrated circuit device) providing a diode 4 in the power control unit 3.

Further, in the above embodiment, use is made of the secondary battery as the backup battery for the primary battery, but it is also possible to use a large capacity capacitor.

Further, in the above embodiment, an alarm terminal ALM was provided and an alarm signal was output based on the operation of the reference voltage detecting circuit 31A, but it is also possible to leave out these functions and to simplify the construction.

As explained above, in the present invention, since the constitution is adopted wherein the secondary power source is charged from the system power source and the primary power source during mounting in the system, the secondary power source is charged from the primary power source during separation from the system, and current for holding the data is supplied from the secondary power source to the memory during replacement of the primary power source, the effect is exhibited that it is possible to fully charge the secondary power source immediately before mounting in the system or in a short time after mounting and to smoothly replace a power source. Further, when the system is battery driven, it is possible to prevent reduction of the power source lifetime of the system.

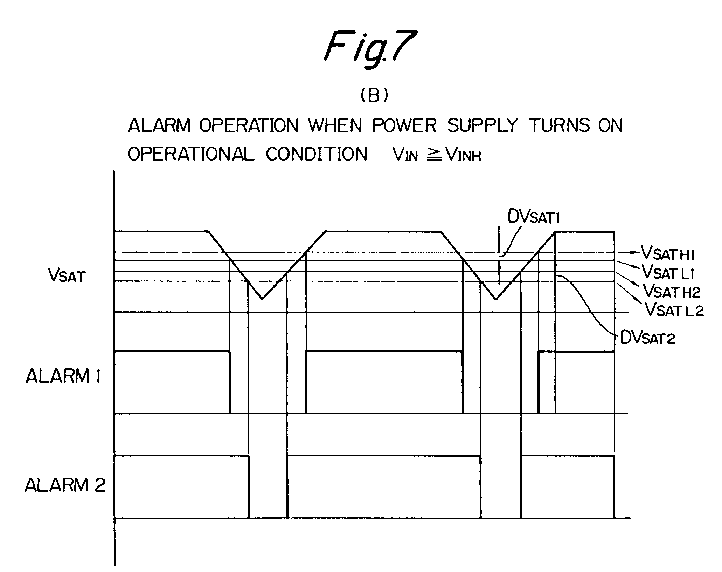

Fig. 7 is a timing chart of an input/output voltage and an alarm operation. In Fig. 7(A), according to a voltage level of an input power source voltage V_{IN}, an output voltage V_{OUT} is produced to provide a RESET signal to each of LOGIC, SRAM, and ROM in 5. When the power source voltage V_{IN} surpasses a voltage level of V_{INH}, a RESET voltage V₁ is output. When the power source voltage V_{IN} falls and is lower than a voltage level V_{INL}, a RESET voltage V₂ (slightly higher than ground level) is output.

When an input power source voltage V_{IN} rises, and the RESET signal surpasses the voltage level V_{INH} or is lower than the voltage level V_{INL}, the RESET signal is output (in the form of a "HIGH" level voltage).

Fig. 7(B) is a timing chart showing an alarm operation when a power supply source turns ON. When a primary battery voltage V_{SAT} drops to lower than both voltage levels V_{SATH1} and V_{SATH2}, or for a period until it rises to surpass both voltage levels V_{SATL1} and V_{SATL2}, each alarm signal ALARM1, ALARM2 outputs a "LOW" level voltage.

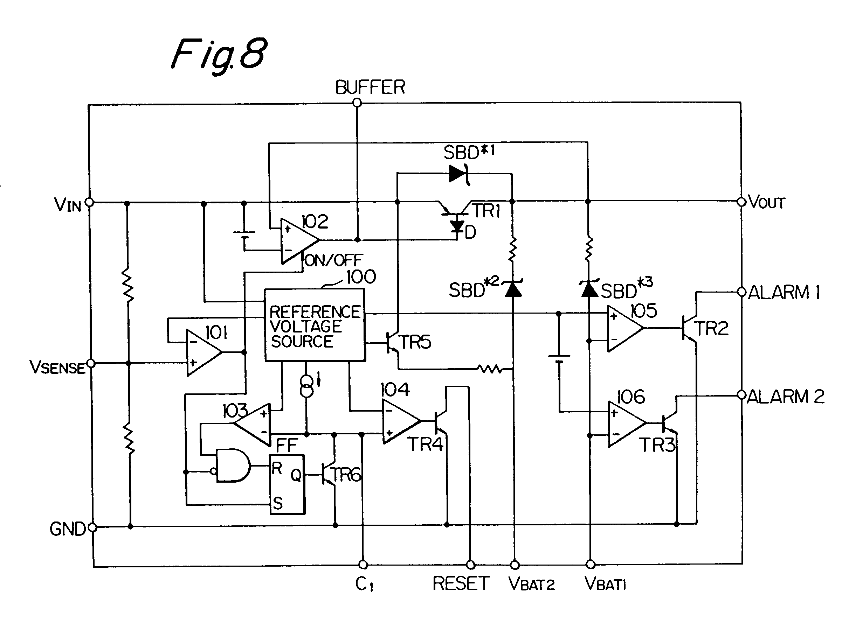

Figure 8 is a detailed circuit diagram of a switching control unit IC11 in Fig. 6, where V_{SENSE} and BUFFER terminals are not used. SBD(*2) and SBD(*3) correspond to diodes 31E, 31D in Fig. 2.

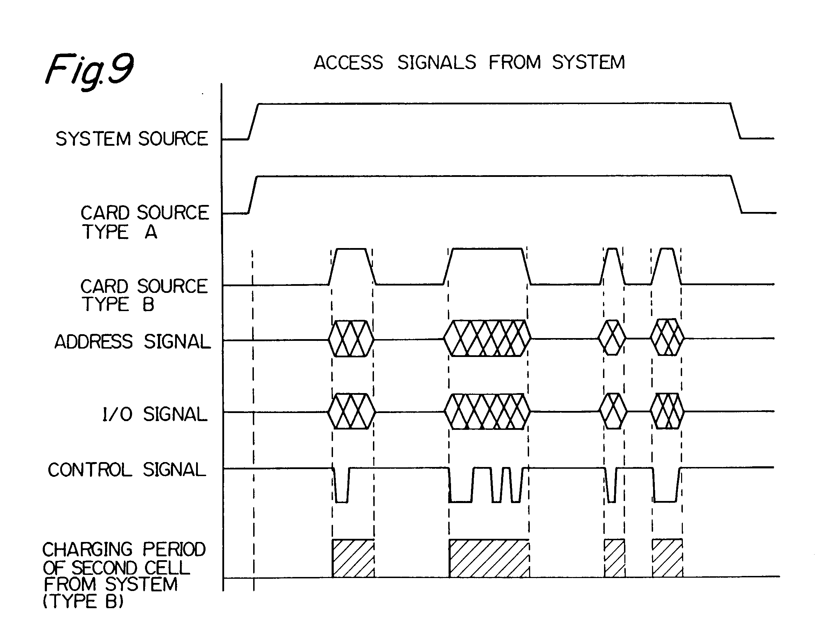

Figure 9 is a timing chart of a system including a memory card device in accordance with the present invention. There are two types of card sources, Type A and Type B. In the figure, waveforms of each signal are shown for a case when the system accesses a memory card.

If an access signal is produced from a system, and a card power source type B is chosen, an address signal, an I/O signal, a control signal and a charging period are produced accordingly.

Since it is required that the body of the system such as a personal computer consumes less power, the system power source supplies power only when a card is accessed. In this case, when a diode 4 in Fig. 2 is not present, the charging of a secondary battery 2 depends on an access from the system to the card and so the charging time of the battery is not constant.

In accordance with the present invention, the charging does not depend on supplying power from the system to the card. Since the charging of the secondary battery can be effected more smoothly with the primary battery connected to the card, the above problem can be solved easily.

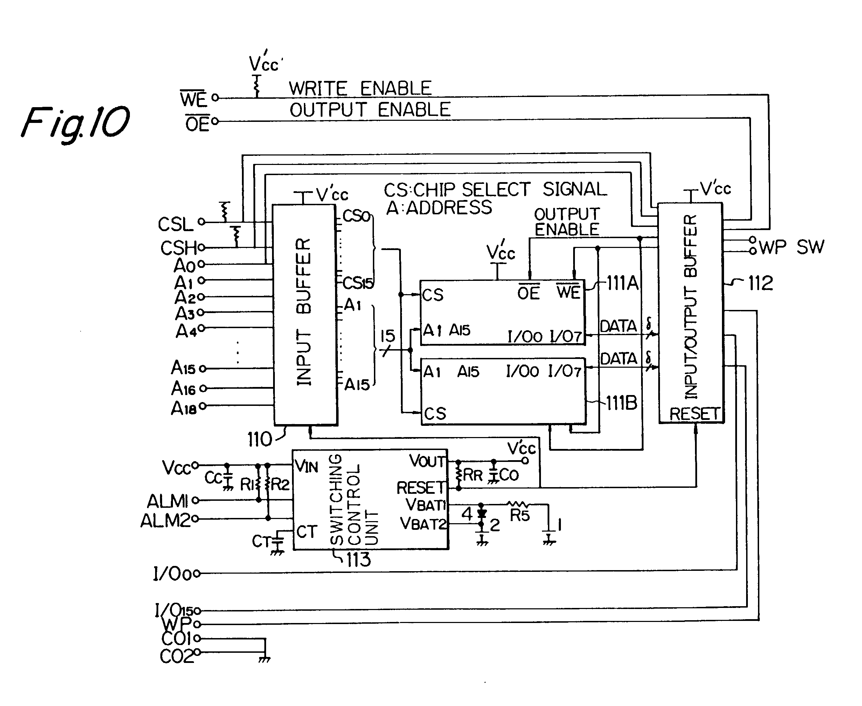

Figure 10 is a block diagram of a memory card including a memory such as a 256K SRAM. Reference numeral 110 denotes an input buffer, 111A and 111B denote SRAM, 112 denotes an input/output buffer, and 113 denotes a switching control unit.

In general, a plurality of SRAMs are mounted in a memory card, although two memories 111A and 111B are illustrated.

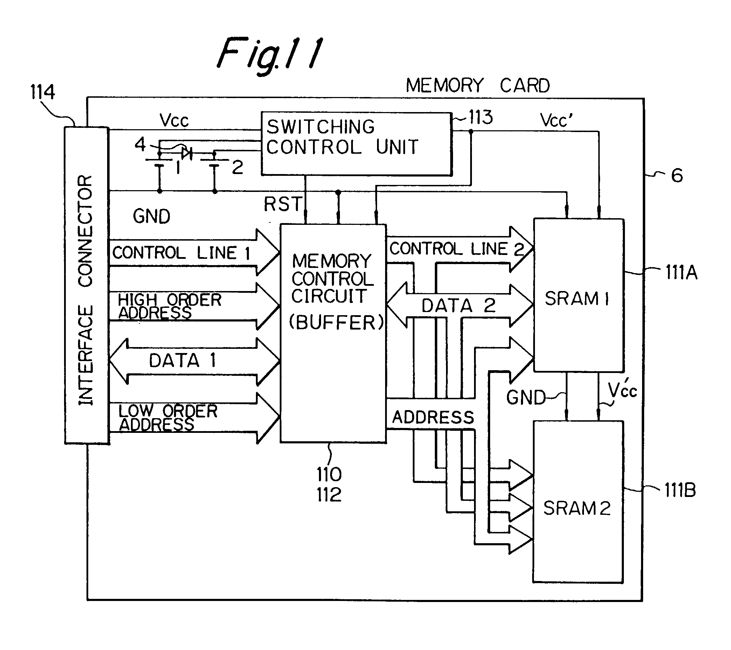

In Fig. 10 and Fig. 11, the input buffer 110 has two functions. First, signals input from a system, for example, input address A₁ to A₁₅ are amplified to be supplied to a built-in IC circuit in a card. Second, chip select signals CS₀ ^{~}CS₁₅ for selecting a plurality of SRAMs are produced using the signals A₀, A₁₆ ^{~}A₁₈ input from the system 7.

The input/output buffer 112 is an interface which inputs or outputs data from the system 7 to the SRAM and vice versa. Amont the various signals, a control line 1 includes signals WE(write enable), OE(output enable), CSL, CSH, WP SW, WP in Fig. 10, a high order address A₀, A₁₆ to A₁₈, a low order address A₁ to A₁₅, data 1, 2 for I/O₀ to I/O₁₅, a control line 2 for chip-select signals CS₀ to CS₁₅, and an address A₁ to A₁₅, respectively.

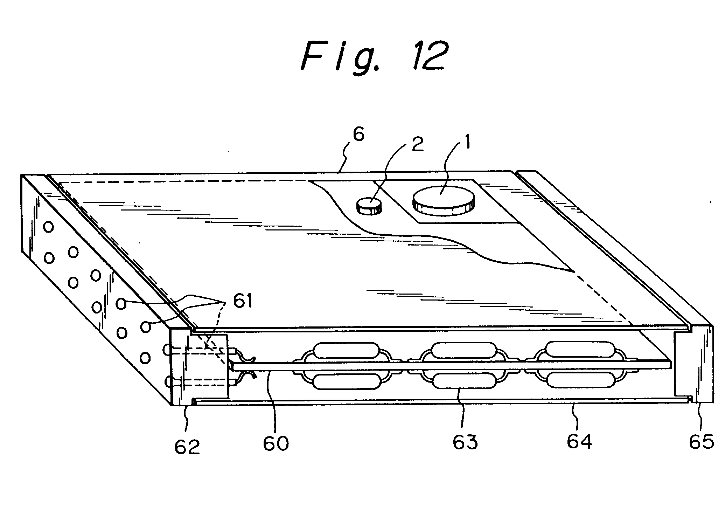

Fig. 12 is an oblique projection drawing with a partial cross-sectional view of an IC card in accordance with the present invention.

Reference numeral 1 denotes a primary battery, 2 a secondary battery, 6 the overall IC card, 61 connector pins, 62 a connector portion, 60 a printed circuit board, 63 a semiconductor chip, 64 a cover plate, and 65 a card frame.

## Claims

1. A card type semiconductor device comprising :
a terminal for receiving an external power source voltage (Vcc);
a semiconductor device (5) operatively connected to said terminal;
a primary battery (1) for supplying a first power source voltage;
a secondary battery (2) for supplying a second power source voltage;
a switching means (31B) for selectively connecting said external power source voltage to said semiconductor device, in response to a signal (V₁);
a reference voltage detecting means (31A) for comparing to a reference voltage (VINH) the external power source voltage, and for supplying the signal (V1) controlling said switching means to supply said external power source voltage to said semiconductor device;
a first circuit means (31D) for supplying said first power source voltage from said primary battery to said semiconductor device, when the external power source voltage is not supplied;
a second circuit means (31E) for supplying said second power source voltage from said second battery to said semiconductor device, when the external power source voltage and said first power source voltage are not being supplied;
characterized in that it further comprises means (4) for connecting said secondary battery (2) to be charged by said first power source voltage supplied from said primary battery (1) when said second power source voltage is lower than said first power source voltage.

2. The device according to claim 1, wherein said first circuit means, said second circuit means, and said means (4) for connecting said secondary battery (2) to be charged to said first power source voltage supplied from said primary battery (1), respectively each comprise at least one diode (31D, 31E4).

3. The device according to claim 1, wherein said switching means (31B) is provided between said terminal (Vcc) and said semiconductor device (5), and is controlled by said reference voltage detecting means (31A) such that, when the exterior power supply voltage is not applied to said terminal, said switching means disconnects said terminal from said semiconductor device.

4. The device according to claim 3, wherein said switching means (31B) controlled by said reference voltage detecting means (31A) is a transistor receiving at its gate the signal from said reference voltage detecting means.

5. The device according to claim 1, wherein the first power source voltage of said primary battery (1) is lower than the voltage of said external power source and a second power source voltage of said secondary battery (2) is also lower than said external power source voltage.

6. The device according to claim 1, wherein there is provided a means for charging said secondary battery (2) by means of said external power source voltage.

7. The device according to claim 1, wherein said primary battery (1) is detachable.

8. The device according to claim 1, wherein said semiconductor device (5) is a volatile memory device.

9. The device according to claim 1, wherein said semiconductor device (6) is a microprocessor chip.

10. The device according to claim 1, wherein said semiconductor device is associated with an apparatus to which said card type semiconductor device (6) is connected, and
wherein said apparatus for connecting said card type semiconductor device, supplies the external power source voltage intermittently to said card type semiconductor device.

11. The device according to claim 10, wherein said semiconductor device (5) comprises a semiconductor memory (5) and the apparatus to which said card type semiconductor device is connected supplies the power source voltage selectively when the device accesses the semiconductor memory.

12. The device according to claim 3, wherein said reference voltage detecting means (31A) additionally detects said first power source voltage and said second power source voltage, for comparing said first power source voltage and said second power source voltage with a predetermined reference value to produce an output alarm signal (ALARM 1).

13. The device according to any one of claims 1 to 12, wherein said means for applying a charging voltage comprises a diode (4) connecting said primary battery and said secondary battery (2) to permit one-way current flow from said first battery to said secondary battery.

14. The device according to any one of claims 1 to 13, wherein said primary battery (1) is of the non-chargeable type and said secondary battery (2) is of the rechargeable type.

## Patentansprüche

1. Eine Halbleitervorrichtung des Kartentyps, mit:
einem Anschluß zum Empfangen einer externen Energiequellenspannung (V_{cc}) ;
einer Halbleitervorrichtung (5), die mit dem genannten Anschluß operativ verbunden ist;
einer Primärbatterie (1) zum Zuführen einer ersten Energiequellenspannung;
einer Sekundärbatterie (2) zum Zuführen einer zweiten Energiequellenspannung;
einem Schaltmittel (31B) zum selektiven Verbinden der genannten externen Energiequellenspannung mit der genannten Halbleitervorrichtung als Reaktion auf ein Signal (V₁);
einem Referenzspannungsdetektionsmittel (31A) zum Vergleichen der externen Energiequellenspannung mit einer Referenzspannung (V_{INH}) und zum Zuführen des Signals (V₁), das das genannte Schaltmittel steuert, um die genannte externe Energiequellenspannung der genannten Halbleitervorrichtung zuzuführen;
einem ersten Schaltungsmittel (31D) zum Zuführen der genannten ersten Energiequellenspannung von der genannten Primärbatterie zu der genannten Halbleitervorrichtung, wenn die externe Energiequelle nicht zugeführt wird;
einem zweiten Schaltungsmittel (31E) zum Zuführen der genannten zweiten Energiequellenspannung von der genannten Sekundärbatterie zu der genannten Halbleitervorrichtung, wenn die externe Energiequellenspannung und die genannte erste Energiequellenspannung nicht zugeführt werden;
dadurch gekennzeichnet, daß sie ferner ein Mittel (4) umfaßt, zum Verbinden der genannten Sekundärbatterie (2), um durch die genannte erste Energiequellenspannung geladen zu werden, die von der genannten Primärbatterie (1) zugeführt wird, wenn die genannte zweite Energiequellenspannung niedriger als die genannte erste Energiequellenspannung ist.

2. Die Vorrichtung nach Anspruch 1, bei der das genannte erste Schaltungsmittel, das genannte zweite Schaltungsmittel und das genannte Mittel (4) zum Verbinden der genannten Sekundärbatterie (2), um geladen zu werden, mit der genannten ersten Energiequellenspannung, die von der genannten Primärbatterie (1) zugeführt wird, jeweilig wenigstens eine Diode (31D, 31E, 4) umfassen.

3. Die Vorrichtung nach Anspruch 1, bei der das genannte Schaltmittel (31B) zwischen dem genannten Anschluß (V_{CC}) und der genannten Halbleitervorrichtung (5) vorgesehen ist und durch das genannte Referenzspannungsdetektionsmittel (31A) so gesteuert wird, daß das genannte Schaltmittel den genannten Anschluß von der genannten Halbleitervorrichtung trennt, wenn die externe Energiequellenspannung nicht auf den genannten Anschluß angewendet wird.

4. Die Vorrichtung nach Anspruch 3, bei der das genannte Schaltmittel (31B), das durch das genannte Referenzspannungsdetektionsmittel (31A) gesteuert wird, ein Transistor ist, der an seinem Gate das Signal von dem genannten Referenzspannungsdetektionsmittel empfängt.

5. Die Vorrichtung nach Anspruch 1, bei der die erste Energiequellenspannung von der genannten Primärbatterie (1) niedriger als die Spannung der genannten externen Energiequelle ist und eine zweite Energiequellenspannung von der genannten Sekundärbatterie (2) auch niedriger als die genannte externe Energiequellenspannung ist.

6. Die Vorrichtung nach Anspruch 1, bei der ein Mittel zum Laden der genannten Sekundärbatterie (2) durch die genannte externe Energiequellenspannung vorgesehen ist.

7. Die Vorrichtung nach Anspruch 1, bei der die genannte Primärbatterie (1) entnehmbar ist.

8. Die Vorrichtung nach Anspruch 1, bei der die genannte Halbleitervorrichtung (5) eine flüchtige Speichervorrichtung ist.

9. Die Vorrichtung nach Anspruch 1, bei der die genannte Halbleitervorrichtung (6) ein Mikroprozessorchip ist.

10. Die Vorrichtung nach Anspruch 1, bei der die genannte Halbleitervorrichtung einer Vorrichtung zugeordnet ist, mit der die genannte Halbleitervorrichtung (6) des Kartentyps verbunden ist, und
bei der die genannte Vorrichtung zum Verbinden der genannten Halbleitervorrichtung des Kartentyps die externe Energiequellenspannung der genannten Halbleitervorrichtung des Kartentyps intermittierend zuführt.

11. Die Vorrichtung nach Anspruch 10, bei der die genannte Halbleitervorrichtung (5) einen Halbleiterspeicher (5) umfaßt und die Vorrichtung, mit der die genannte Halbleitervorrichtung des Kartentyps verbunden ist, die Energiequellenspannung selektiv zuführt, wenn die Vorrichtung auf den Halbleiterspeicher zugreift.

12. Die Vorrichtung nach Anspruch 3, bei der das genannte Referenzspannungsdetektionsmittel (31A) zusätzlich die genannte erste Energiequellenspannung und die genannte zweite Energiequellenspannung detektiert, zum Vergleichen der genannten ersten Energiequellenspannung und der genannten zweiten Energiequellenspannung mit einem vorbestimmten Referenzwert, um ein Ausgangsalarmsignal (ALARM1) zu erzeugen.

13. Die Vorrichtung nach irgendeinem der Ansprüche 1 bis 12, bei der das genannte Mittel zum Anwenden einer Ladespannung eine Diode (4) umfaßt, die die genannte Primärbatterie und die genannte Sekundärbatterie (2) verbindet, um von der genannten Primärbatterie zu der genannten Sekundärbatterie einen Einwegstrom fließen zu lassen.

14. Die Vorrichtung nach irgendeinem der Ansprüche 1 bis 13, bei der die genannte Primärbatterie (1) vom nichtaufladbaren Typ ist und die genannte Sekundärbatterie (2) vom wiederaufladbaren Typ ist.

## Revendications

1. Dispositif à semiconducteur du type carte, comprenant :
une borne destinée à recevoir une tension de source d'alimentation électrique externe (V_{cc});
un dispositif à semiconducteur (5) fonctionnellement connecté à ladite borne;
une batterie électrique primaire (1) servant à fournir une tension de première source d'alimentation électrique ;
une batterie électrique secondaire (2) servant à fournir une tension de deuxième source d'alimentation électrique ;
un moyen de commutation (31B) servant à connecter sélectivement ladite tension de source d'alimentation électrique externe audit dispositif à semiconducteur, en réponse à un signal (V₁) ;
un moyen de détection de tension de référence (31A) servant à comparer, à une tension de référence (V_{INH}), la tension de source d'alimentation électrique externe, et à délivrer le signal (V₁) commandant ledit moyen de commutation afin de fournir ladite tension de source d'alimentation électrique externe audit dispositif à semiconducteur ;
un premier moyen, formant un circuit, (31D) servant à fournir ladite tension de première source d'alimentation électrique, qui vient de ladite batterie primaire, audit dispositif à semiconducteur, lorsque la tension de source d'alimentation électrique externe n'est pas fournie ;
un deuxième moyen, formant un circuit, (31E) servant à fournir ladite tension de deuxième source d'alimentation électrique, venant de ladite batterie secondaire, audit dispositif à semiconducteur, lorsque la tension de source d'alimentation électrique externe et ladite tension de première source d'alimentation électrique ne sont pas fournies ;
caractérisé en ce qu'il comprend en outre un moyen (4) servant à connecter ladite batterie secondaire (2) afin qu'elle soit chargée par ladite tension de première source d'alimentation électrique fournie par ladite batterie primaire (1) lorsque ladite tension de deuxième source d'alimentation électrique est inférieure à ladite tension de première source d'alimentation électrique.

2. Dispositif selon la revendication 1, où ledit premier moyen formant un circuit, ledit deuxième moyen formant un circuit et ledit moyen (4) servant à connecter ladite batterie secondaire (2) devant être chargée par ladite tension de première source d'alimentation électrique fournie par ladite batterie primaire (1), comprennent respectivement chacun au moins une diode (31D, 31E, 4).

3. Dispositif selon la revendication 1, où ledit moyen de commutation (31B) est placé entre ladite borne (V_{cc}) et ledit dispositif à semiconducteur (5), et est commandé par ledit moyen de détection de tension de référence (31A) de façon que, lorsque la tension d'alimentation électrique extérieure n'est pas appliquée à ladite borne, ledit moyen de commutation déconnecte ladite home vis-à-vis dudit dispositif à semiconducteur.

4. Dispositif selon la revendication 3, où ledit moyen de commutation (31B) commandé par ledit moyen de détection de tension de référence (31A) est un transistor qui reçoit sur sa grille le signal venant dudit moyen de détection de tension de référence.

5. Dispositif selon la revendication 1, où la tension de première source d'alimentation électrique de ladite batterie primaire (1) est inférieure à la tension de ladite source d'alimentation électrique externe, et la tension de deuxième source d'alimentation électrique de ladite batterie secondaire (2) est également inférieure à ladite tension de source d'alimentation électrique externe.

6. Dispositif selon la revendication 1, où il est prévu un moyen permettant de charger ladite batterie secondaire (2) au moyen de ladite tension de source d'alimentation électrique externe.

7. Dispositif selon la revendication 1, où ladite batterie primaire (1) est détachable.

8. Dispositif selon la revendication 1, où ledit dispositif à semiconducteur (5) est un dispositif du type mémoire volatile.

9. Dispositif selon la revendication 1, où ledit dispositif à semiconducteur (5) est une puce de microprocesseur.

10. Dispositif selon la revendication 1, où ledit dispositif à semiconducteur est associé à un appareil auquel ledit dispositif à semiconducteur du type carte (5) est connecté, et
où ledit appareil servant à connecter ledit dispositif du type carte fournit la tension de source d'alimentation électrique externe par intermittence audit dispositif à semiconducteur du type carte.

11. Dispositif selon la revendication 10, où ledit dispositif à semiconducteur (5) comprend une mémoire semiconductrice (5) et l'appareil auquel ledit dispositif à semiconducteur du type carte est connecté fournit sélectivement la tension d'alimentation électrique lorsque le dispositif fait accès à la mémoire semiconductrice.

12. Dispositif selon la revendication 3, où ledit moyen de détection de tension de référence (31A) détecte en outre ladite tension de première source d'alimentation électrique et ladite tension de deuxième source d'alimentation électrique, afin de comparer ladite tension de première source d'alimentation électrique et ladite tension de deuxième source d'alimentation électrique avec une valeur de référence prédéterminée de façon à produire un signal d'alarme de sortie (ALARME 1).

13. Dispositif selon l'une quelconque des revendications 1 à 12, où ledit moyen servant à appliquer une tension de charge comprend une diode (4) connectant ladite batterie primaire (1) et ladite batterie secondaire (2) de façon à permettre la circulation unidirectionnelle d'un courant, de ladite batterie primaire à ladite batterie secondaire.

14. Dispositif selon l'une quelconque des revendications 1 à 13, où ladite batterie primaire (1) est du type non rechargeable et ladite batterie secondaire (2) est du type rechargeable.
